# EUROPEAN PATENT APPLICATION

(11) **EP 4 579 747 A1**
(43) Date of publication of application: **02.07.2025**
(21) Application number: 23899689.6
(22) Date of filing: 08.11.2023
(51) Int. Cl.: H01L 25/16

(54) **INTELLIGENT POWER MODULE AND POWER CONVERSION DEVICE**

(30) Priority: 07.12.2022 CN 202211567621
(71) Applicant: Huawei Digital Power Technologies Co., Ltd., Shenzhen, Guangdong 518043 (CN)
(72) Inventor: LIAO, Xiaojing, Shenzhen, Guangdong 518043 (CN); PENG, Hao, Shenzhen, Guangdong 518043 (CN); YAO, Weiwei, Shenzhen, Guangdong 518043 (CN)
(74) Representative: Isarpatent
(86) International application number: PCT/CN2023/130480
(87) International publication number: WO 2024/120109

(57) **Abstract**

This application provides an intelligent power module and a power conversion device. The intelligent power module includes a power part and a signal part, and the power part and the signal part are stacked in a first direction. The power part includes a power chip and a first insulation layer, and the power chip is embedded in the first insulation layer. The signal part includes a signal processing chip, the signal processing chip and the power chip overlap with each other in the first direction, and the signal processing chip is electrically connected to the power chip. In this solution, the power part and the signal part are stacked in the first direction, so that the power chip and the signal processing chip are disposed hierarchically in the first direction. In addition, the power chip and the signal processing chip overlap with each other in the first direction, so that the power chip and the signal processing chip are stacked in three-dimensional space. In this way, an overall size of the module can be small, a plastic packaging stress on the module is small, and a chip damage risk can be reduced. In addition, the power chip is close to the signal processing chip, so that parasitic inductance and resistance can be small. In this way, a voltage stress on the chip is small, and efficiency of the module is high.

## Description

### CROSS-REFERENCE TO RELATED APPLICATIONS

This application claims priority to Chinese Patent Application No. 202211567621.9, filed with the China National Intellectual Property Administration on December 7, 2022 and entitled "INTELLIGENT POWER MODULE AND POWER CONVERSION DEVICE", which is incorporated herein by reference in its entirety.

### TECHNICAL FIELD

This application relates to the field of electronic device technologies, and in particular, to an intelligent power module and a power conversion device.

### BACKGROUND

Intelligent power modules (IPMs) are advanced power switching devices, and have advantages of high current density, a low saturation voltage, and high-voltage resistance of high-power transistors and advantages of high input impedance, a high switching frequency, and low driving power of metal-oxide-semiconductor field-effect transistors (MOSFETs). In addition, integrating logic, control, detection, and protection circuits, the intelligent power modules are easy to use, thereby reducing system sizes and development time, and also enhancing system reliability; adapt to a current development trend of modularization, integration, and power integrated circuits (PICs) of power devices; and are increasingly widely used in the field of power electronics.

In a current packaging solution of the intelligent power modules, driver chips and power chips are arranged in a flat manner, and the driver chips are carried by additional frames or circuit boards. In this case, distances between the driver chips and the power chips are long, and the driver chips and the power chips are interconnected through wire bonding. The intelligent power modules using this packaging solution are large in size, and plastic packaging stresses are large. Consequently, chip damage risks are high, and chips are vulnerable to problems such as warping and cracking. In addition, parasitic inductance and resistance of the interconnection manner of wire bonding are large. As a result, voltage stresses on chips are large, switching response speeds of the modules are slow, and switching frequencies are low, leading to low efficiency of the modules.

### SUMMARY

This application provides an intelligent power module and a power conversion device, to reduce a size of a module and reduce a chip damage risk.

According to a first aspect, this application provides an intelligent power module. The intelligent power module may include a power part and a signal part, and the power part and the signal part may be stacked in a first direction. The power part may include a power chip and a first insulation layer, and the power chip is embedded in the first insulation layer. The signal part may include a signal processing chip, and the signal processing chip and the power chip may overlap with each other in the first direction, so that the power chip and the signal processing chip can be stacked in three-dimensional space. The signal processing chip may be electrically connected to the power chip.

According to the technical solution provided in this application, the power part and the signal part are stacked in the first direction, so that the power chip and the signal processing chip are disposed hierarchically in the first direction. In addition, the power chip and the signal processing chip overlap with each other in the first direction, so that the power chip and the signal processing chip are stacked in three-dimensional space. In this way, an overall size of the module can be small, a plastic packaging stress on the module is small, a chip damage risk can be reduced, and a chip is not vulnerable to problems such as warping and cracking. In addition, because the power chip and the signal processing chip are stacked in the three-dimensional space, the power chip is close to the signal processing chip, so that a conductive member that connects to the power chip and the signal processing chip can be short, and parasitic inductance and resistance can be controlled to be within a small range. In this way, a voltage stress on the chip is small, a switching response speed of the module is fast, and a switching frequency is high, and efficiency of the module is high. In general, the intelligent power module provided in this embodiment of this application can implement miniaturization and a low parasitic parameter, and can meet use requirements in more application scenarios. In addition, the power chip is embedded in the first insulation layer, so that a position of the power chip is stable, and stability of the module can be improved.

When the signal processing chip is specifically connected to the power chip, the signal processing chip may be electrically connected to the power chip through a first via. The first via may be short, so that the parasitic inductance and the resistance can be controlled to be within a small range. In this way, a voltage stress on the chip can be reduced, so that a switching response speed and a switching frequency of the module can be improved.

In a specific implementation solution, the power part may further include a first routing layer, the first routing layer may be disposed on a side that is of the power chip and that is close to the signal part, and the power chip may be electrically connected to the first routing layer. In this way, a connection between the power chip and the signal processing chip is facilitated.

In a specific implementation solution, the first routing layer may be electrically connected to the first via, so that the power chip can be electrically connected to the first via. In this way, the power chip can be electrically connected to the signal processing chip. In other words, the power chip can be electrically connected to the signal processing chip through the first routing layer and the first via.

In a specific implementation solution, the power part may further include a second routing layer, the second routing layer may be disposed on a side that is of the power chip and that is away from the signal part, and the power chip may be electrically connected to the second routing layer. In this way, arrangement of the power chip is facilitated.

In a specific implementation solution, the second routing layer may be electrically connected to the first routing layer through a second via. In this way, a connection between the second routing layer and the first routing layer is facilitated. The connection between the second routing layer and the first routing layer also provides more possibilities for internal and external connections of the power chip, and can meet various disposition requirements.

In a specific implementation solution, the signal part may further include a third routing layer, the third routing layer may be disposed on a side that is of the signal processing chip and that is close to the power part, the signal processing chip may be electrically connected to the third routing layer, and the power chip may be electrically connected to the third routing layer. The third routing layer is disposed, to facilitate the connection between the signal processing chip and the power chip and facilitate external connections of the signal processing chip and the power chip. Specifically, the power chip may be electrically connected to the third routing layer through the first routing layer and the first via.

In a specific implementation solution, the third routing layer may be electrically connected to the first routing layer through the first via, so that the signal processing chip can be electrically connected to the power chip through the third routing layer, the first via, and the first routing layer.

In a specific implementation solution, the third routing layer may be electrically connected to a passive component. The passive component may be a resistor, a capacitor, an inductor, a sensor, or the like, and may enrich a function of the module.

In a specific implementation solution, the third routing layer may be further electrically connected to a plurality of pins, a first end of the pin may be electrically connected to the third routing layer, and a second end of the pin may extend out of the signal part. The pin is disposed, to facilitate a connection between the module and an external printed circuit board or the like.

In a specific implementation solution, the signal part may further include a second insulation layer, and the signal processing chip is embedded in the second insulation layer. The second insulation layer may have an insulation and protection function, and may further have a positioning function, so that a position of the signal processing chip is stable.

In a specific implementation solution, the intelligent power module may further include a heat dissipation part, the heat dissipation part and the power part may be stacked, and the power part may be located between the heat dissipation part and the signal part. In this way, a heat dissipation capability of the module can be improved.

In a specific implementation solution, the heat dissipation part may include a thermally conductive insulation layer and a heat dissipation member, and the heat dissipation member may be fastened to the power part through the thermally conductive insulation layer. In this way, heat dissipation of the power part can be accelerated, so that a heat dissipation speed of the module can be increased.

In a specific implementation solution, a heat dissipation fin may be disposed on a side that is of the heat dissipation member and that is away from the power part. In this way, heat dissipation efficiency of the module can be improved.

According to a second aspect, this application provides a power conversion device. The power conversion device may include a circuit board and a power conversion circuit that includes at least one intelligent power module according to any implementations of the first aspect. The intelligent power module may be disposed on the circuit board, the intelligent power module may be electrically connected to the circuit board, and the power conversion circuit may be configured to perform alternating current-direct current conversion. The intelligent power module is small in size, performance is stable, and efficiency is high, so that the power conversion device can correspondingly be small in size, and performance is good.

### BRIEF DESCRIPTION OF DRAWINGS

FIG. 1 is a diagram of a structure of an intelligent power module according to an embodiment of this application;
FIG. 2 is a diagram of a structure of an intelligent power module according to another embodiment of this application;
FIG. 3 is a diagram of a structure of an intelligent power module according to another embodiment of this application;
FIG. 4 is a diagram of a structure of an intelligent power module according to another embodiment of this application;
FIG. 5 is a diagram of a structure of an intelligent power module according to another embodiment of this application; and
FIG. 6 is a diagram of a structure of an intelligent power module according to another embodiment of this application.

### Reference numerals:

100: power part; 200: signal part; 300: heat dissipation part; 400: heat sink; 101: power chip; 102: first via;
103: first routing layer; 104: second routing layer; 105: second via; 106: third via; 107: first insulation layer;
201: signal processing chip; 202: third routing layer; 203: passive component; 204: power pin; 205: signal pin;
206: second insulation layer; 301: thermally conductive insulation layer; 302: heat dissipation member; 303: heat dissipation fin.

### DESCRIPTION OF EMBODIMENTS

The following describes in detail embodiments of this application with reference to accompanying drawings.

For ease of understanding, an application scenario of an intelligent power module in this application is first described. The intelligent power module provided in this embodiment of this application may be adapted to a power conversion device. In a possible application scenario, the intelligent power module provided in this embodiment of this application may be used in a power supply system, for example, may be used as a system-level power transformation functional module, and is configured to implement functions such as voltage boosting and bucking and alternating current-direct current conversion. During specific disposition, the intelligent power module provided in this embodiment of this application may be disposed on a circuit board, and is electrically connected to the circuit board.

The intelligent power module usually includes a driver chip, a power chip, and another electronic component. In a current packaging solution of the intelligent power module, the driver chip and the power chip are arranged in a flat manner, and the driver chip is usually carried by an additional frame or a printed circuit board (PCB). In this case, a distance between the driver chip and the power chip is long, and driver chip and the power chip are usually interconnected through wire bonding. The intelligent power module using this packaging solution is large in size, and costs are high. In addition, a plastic packaging stress is large. Consequently, a chip damage risk is high, and a chip is vulnerable to problems such as warping and cracking. In addition, parasitic inductance and resistance of the interconnection manner of wire bonding are large. As a result, a voltage stress on a chip is large, a switching response speed of the module is slow, and a switching frequency is low, leading to low overall efficiency of the module.

In view of this, an embodiment of this application provides an intelligent power module, to reduce a size of the module and reduce a chip damage risk.

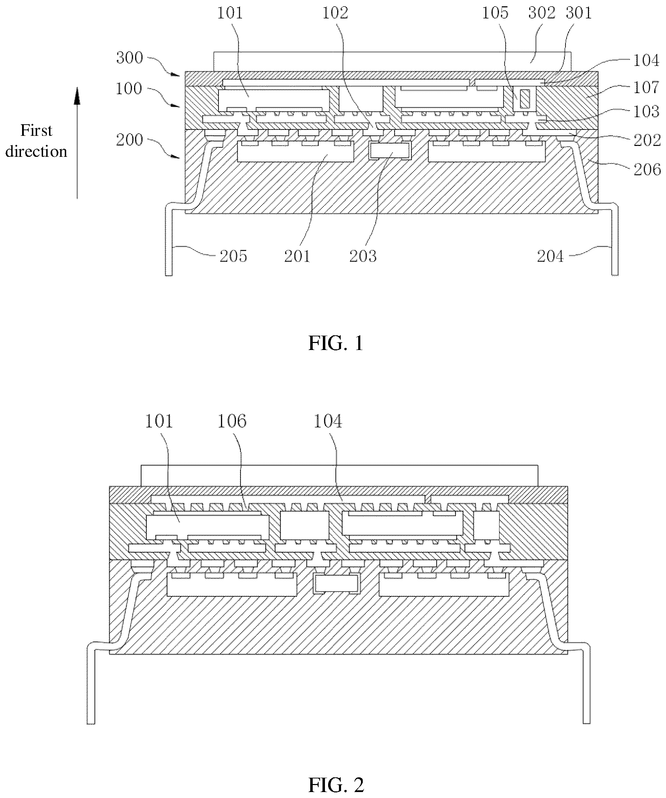

First, FIG. 1 is a diagram of a structure of an intelligent power module according to an embodiment of this application. As shown in FIG. 1, the intelligent power module provided in this embodiment of this application may include a power part 100 and a signal part 200. The power part 100 and the signal part 200 may be stacked in a first direction. The power part 100 may include a power chip 101. The signal part 200 may drive and control the power chip 101, and may further perform related intelligent control. The signal part 200 may include a signal processing chip 201. During specific implementation, the signal processing chip 201 and the power chip 101 may overlap with each other in the first direction, and the signal processing chip 201 is electrically connected to the power chip 101. Overlapping in this embodiment of this application means that the two devices: the signal processing chip 201 and the power chip 101, at least partially overlap with each other in the first direction. In other words, a projection of one device onto a placement surface of the other device along the first direction at least partially overlaps with a projection of the other device onto the placement surface of the other device along the first direction. Specifically, when the signal processing chip 201 and the power chip 101 are disposed, sizes of the signal processing chip 201 and the power chip 101 may be the same, or may be different. The signal processing chip 201 and the power chip 101 may partially or completely overlap with each other.

According to the intelligent power module provided in this embodiment of this application, the power part 100 and the signal part 200 are stacked in the first direction, so that the power chip 101 and the signal processing chip 201 are disposed hierarchically in the first direction. In addition, the power chip 101 and the signal processing chip 201 overlap with each other in the first direction, so that the power chip 101 and the signal processing chip 201 are stacked in three-dimensional space. In this way, an overall size of the module can be small, a plastic packaging stress on the module is small, a chip damage risk can be reduced, and the chip is not vulnerable to problems such as warping and cracking. In addition, because the power chip 101 and the signal processing chip 201 are stacked in the three-dimensional space, the power chip 101 is close to the signal processing chip 201, so that a conductive member that connects to the power chip 101 and the signal processing chip 201 can be short, and parasitic inductance and resistance can be controlled to be within a small range. In this way, a voltage stress on the chip is small, a switching response speed of the module is fast, and a switching frequency is high, and efficiency of the module is high.

During specific implementation, the power chip 101 may be a high-power device, such as an insulated gate bipolar transistor (IGBT), a field-effect transistor (MOSFET), or a diode. The signal processing chip 201 may be a low-power device, such as a driver IC or a control IC.

In a possible application scenario, the intelligent power module provided in this embodiment of this application may be used as a power transformation functional module of a power supply system. In this case, the power chip 101 may be a MOSFET, and the signal processing chip 201 may be a driver chip, to implement functions such as voltage boosting and bucking and alternating current-direct current conversion. During specific application, the entire module and a printed circuit board outside the module may be interconnected. According to an actual requirement, in addition to the driver chip, the signal part 200 of the module may further include components such as a resistor, a capacitor, and an inductor.

In a possible embodiment, the signal processing chip 201 may be electrically connected to the power chip 101 through a first via 102. The first via 102 may be formed in the signal part 200 and the power part 100. Specifically, a through via may be formed in the signal part 200 and the power part 100, and the through via is plated with copper or another conductive metal, to form the first via 102. In other words, the first via 102 may be of a metal through-via structure. During specific implementation, in addition to the metal through-via structure, the signal processing chip 201 may be further electrically connected to the power chip 101 through a metal trace disposed in the signal part 200 and the power part 100, for example, through a copper trace.

In a possible embodiment, the power part 100 may further include a first routing layer 103, the first routing layer 103 may be disposed on a side that is of the power chip 101 and that is close to the signal part 200, and the power chip 101 may be electrically connected to the first routing layer 103. Specifically, the first routing layer 103 may be of a sheet-like structure made of copper, and the power chip 101 may be electrically connected to the first routing layer 103 through soldering. The first routing layer 103 may alternatively be made of another conductive metal, or may alternatively be in another shape. A material and a shape of the first routing layer 103 are not limited in this embodiment of this application.

During actual disposing, the first via 102 may be further electrically connected to the first routing layer 103. Specifically, the first via 102 may be electrically connected to the first routing layer 103 through soldering, or the first via 102 and the first routing layer 103 may be integrally formed. The first via 102 is electrically connected to the first routing layer 103, so that the first via 102 can be electrically connected to the power chip 101. In this way, the signal processing chip 201 can be electrically connected to the power chip 101. In other words, the signal processing chip 201 can be electrically connected to the power chip 101 through the first via 102 and the first routing layer 103. During specific implementation, according to an actual requirement, the power part 100 may include one or more first routing layers 103 for another component to be disposed on. The plurality of first routing layers 103 may be all electrically connected, or partially electrically connected, or not electrically connected to each other. The plurality of first routing layers 103 may be disposed in a flat manner or may be stacked. When the plurality of first routing layers 103 are stacked, adjacent first routing layers 103 may be electrically connected through a metal through-via structure or a metal trace. Some first routing layers 103 may be disposed on one side or two sides that are of the power chip 101 and that are in a direction perpendicular to the first direction, that is, may be disposed on a left side and/or a right side of the power chip 101 in FIG. 1. When the power part 100 includes the plurality of first routing layers 103, the power chip 101 may be electrically connected to one first routing layer 103 closest to the power chip 101.

In a possible embodiment, the power part 100 may further include a second routing layer 104, and the second routing layer 104 may be disposed on a side that is of the power chip 101 and that is away from the signal part 200. When the power part 100 is specifically formed, the power chip 101 may be carried by the second routing layer 104. The power chip 101 may be electrically connected to the second routing layer 104. Specifically, the second routing layer 104 may be of a sheet-like structure made of copper. The second routing layer 104 may alternatively be made of another conductive metal, or may alternatively be in another shape. A material and a shape of the second routing layer 104 are not limited in this embodiment of this application.

In a possible specific implementation, the power chip 101 and the second routing layer 104 may be metalized and directly connected to be electrically connected. Metallization in this embodiment of this application means that a metal layer is deposited on the second routing layer 104 through physical vapor deposition, and then different patterns are etched to match and connect to a pin of the power chip 101.

FIG. 2 is a diagram of a structure of an intelligent power module according to another embodiment of this application. As shown in FIG. 2, in another possible specific implementation, the power chip 101 may be electrically connected to the second routing layer 104 through a third via 106. Specifically, the third via 106 may be of a metal through-via structure.

Still refer to FIG. 1. During specific implementation, the second routing layer 104 may protrude from a surface of the power part 100, or the second routing layer 104 may be flush with the surface of the power part 100. In this way, the second routing layer 104 may accelerate heat dissipation. This helps quick dissipation of heat of the power chip 101. Similarly, according to an actual requirement, the power part 100 may include one or more second routing layers 104 for another component to be disposed on. The plurality of second routing layers 104 may be all electrically connected, or partially electrically connected, or not electrically connected to each other. The plurality of second routing layers 104 may be disposed in a flat manner or may be stacked. When the plurality of second routing layers 104 are stacked, adjacent second routing layers 104 may be electrically connected through a metal through-via structure or a metal trace. Some second routing layers 104 may further be disposed on one side or two sides that are of the power chip 101 and that are in the direction perpendicular to the first direction, that is, may be disposed on the left side and/or the right side of the power chip 101 in FIG. 1. When the power part 100 includes the plurality of second routing layers 104, the power chip 101 may be electrically connected to one second routing layer 104 closest to the power chip 101, and a second routing layer 104 farthest away from the power chip 101 may protrude from the surface of the power part 100 or be flush with the surface of the power part 100.

In a possible embodiment, according to an actual connection requirement, the second routing layer 104 may be electrically connected to the first routing layer 103 through a second via 105. The second via 105 may be formed in the power part 100. Specifically, a through via may be formed in the power part 100, and the through via is plated with copper or another conductive metal, to form the second via 105. In other words, the second via 105 may be of a metal through-via structure. In addition to the metal through-via structure, the second routing layer 104 may be further electrically connected to the first routing layer 103 through a copper column or a columnar structure made of another conductive metal.

In a specific implementation, the power part 100 may further include a first insulation layer 107, and the power chip 101 may be embedded in the first insulation layer 107. Specifically, the power chip 101 and another component that may be actually required may be embedded in the first insulation layer 107 to form the power part 100. In other words, the power chip 101 may be packaged in the first insulation layer 107 through embedding. During specific implementation, the first insulation layer 107 may be formed by using a potting process.

During actual disposing, the first routing layer 103 may be disposed in the first insulation layer 107. In other words, the first routing layer 103 may be packaged in the first insulation layer 107 through embedding. The second routing layer 104 may protrude from the first insulation layer 107, or the second routing layer 104 may be flush with a surface of the first insulation layer 107. Relative positions of the power chip 101, the first routing layer 103, and the second routing layer 104 may be fixed by the first insulation layer 107.

In a possible embodiment, the signal part 200 may further include a third routing layer 202, and the third routing layer 202 may be disposed on a side that is of the signal processing chip 201 and that is close to the power part 100. When the signal part 200 is specifically formed, the signal processing chip 201 may be carried by the third routing layer 202. The signal processing chip 201 may be electrically connected to the third routing layer 202. Specifically, the third routing layer 202 may be of a sheet-like structure made of copper, and the signal processing chip 201 may be electrically connected to the third routing layer 202 through soldering. The power chip 101 may be further electrically connected to the third routing layer 202. The third routing layer 202 may alternatively be made of a conductive metal in addition to copper, or may be in another shape. A material and a shape of the third routing layer 202 are not limited in this embodiment of this application. During specific implementation, according to an actual requirement, similarly, the signal part 200 may include one or more third routing layers 202 for another component to be disposed on. The plurality of third routing layers 202 may be all electrically connected, or partially electrically connected, or not electrically connected to each other. The plurality of third routing layers 202 may be disposed in a flat manner or may be stacked. When the plurality of third routing layers 202 are stacked, adjacent third routing layers 202 may be electrically connected through a metal through-via structure. When the signal part 200 includes the plurality of third routing layers 202, the signal processing chip 201 may be electrically connected to one third routing layer 202 closest to the signal processing chip 201.

During specific implementation, the third routing layer 202 may be disposed inside the signal part 200 or on a surface of the signal part 200, or may be disposed inside the power part 100 or on the surface of the power part 100, or may be disposed in a junction area between the signal part 200 and the power part 100. In other words, a part of the third routing layer 202 may be located in the signal part 200, and the other part is located in the power part 100.

During specific disposition, the first via 102 may be electrically connected to the third routing layer 202. Specifically, the first via 102 may be electrically connected to the third routing layer 202 through soldering, or the first via 102 and the third routing layer 202 may be integrally formed. The first via 102 is electrically connected to the third routing layer 202, so that the first via 102 can be electrically connected to the signal processing chip 201. In this way, the power chip 101 can be electrically connected to the signal processing chip 201. In other words, the power chip 101 can be electrically connected to the signal processing chip 201 through the first via 102 and the third routing layer 202. Alternatively, the power chip 101 may be electrically connected to the third routing layer 202 through the second routing layer 104, the second via 105, the first routing layer 103, and the first via 102, to be electrically connected to the signal processing chip 201.

With reference to the foregoing specific embodiment, the first via 102 may be connected to both the first routing layer 103 and the third routing layer 202 through soldering. In other words, the third routing layer 202 may be electrically connected to the first routing layer 103 through the first via 102. Alternatively, the first via 102, the first routing layer 103, and the third routing layer 202 may be integrally formed. The power chip 101 may be electrically connected to the signal processing chip 201 through the first routing layer 103, the first via 102, and the third routing layer 202.

In a possible embodiment, a passive component 203 may be disposed on the third routing layer 202. When the signal part 200 is specifically formed, the passive component 203 may be carried by the third routing layer 202. During actual application, the passive component 203 may be a resistor, a capacitor, an inductor, a sensor, or the like, and may be selected according to an actual requirement. One or more passive components 203 may be disposed on the third routing layer 202. The passive component 203 is electrically connected to the third routing layer 202. Specifically, the passive component 203 may be electrically connected to the third routing layer 202 through soldering. The third routing layer 202 is disposed, so that the passive component 203 can be additionally disposed to make full use of internal space of the signal part 200, to enrich a function of the module. A plurality of passive components 203 may be further centralized, or the signal processing chip 201 and the passive component 203 may be centralized, so that an overall size of the module can be reduced.

In a possible embodiment, a pin may be disposed on the third routing layer 202, and the pin is electrically connected to the third routing layer 202. Specifically, the pin may be electrically connected to the third routing layer 202 through soldering. During actual disposing, a first end of the pin may be electrically connected to the third routing layer 202, and a second end of the pin may extend out of the signal part 200, to be electrically connected to a printed circuit board outside the module, so that the module and an external printed circuit board are interconnected. According to an actual requirement, a plurality of pins may be disposed on the third routing layer 202, and the pins may be distributed at any position on a side surface of the module. A quantity and distribution positions of the pins are not limited in this embodiment of this application. During specific implementation, a part of the plurality of pins may be used as a power pin, and the other part may be used as a signal pin. As shown in FIG. 1, the power pin 204 may be electrically connected to the power chip 101. Specifically, the power pin 204 may be electrically connected to the power chip 101 through the third routing layer 202, the first via 102, the first routing layer 103, the second via 105, and the second routing layer 104, or the power pin 204 may be electrically connected to the power chip 101 through the third routing layer 202, the first via 102, and the first routing layer 103. The signal pin 205 may be electrically connected to the signal processing chip 201. Specifically, the signal pin 205 may be electrically connected to the signal processing chip 201 through the third routing layer 202.

During specific implementation, the pin may be made of copper or another conductive metal material. In a possible specific implementation, the pin may be formed into a plurality of shapes through bending, to be used in a plurality of assembly manners, for example, be inserted into or surface-mounted onto a printed circuit board outside the module.

In a possible specific implementation, the power pin 204 is used as an example. A second end of the pin may be in a straight line shape disposed along the first direction, to facilitate insertion into an external printed circuit board.

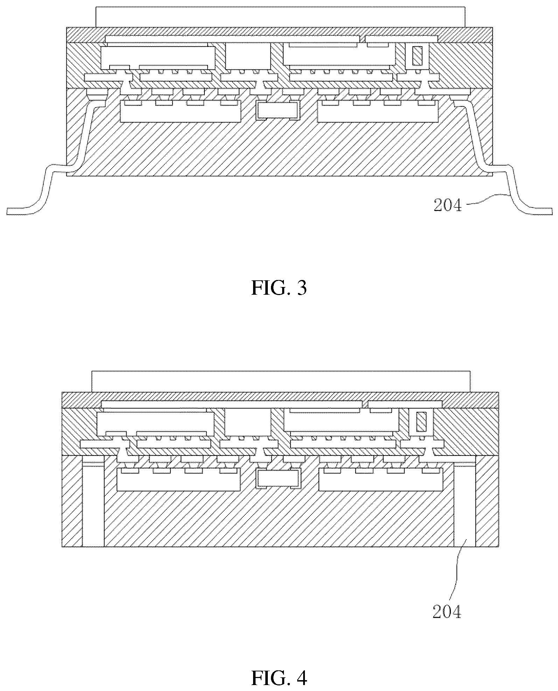

FIG. 3 is a diagram of a structure of an intelligent power module according to another embodiment of this application. As shown in FIG. 3, in another possible specific implementation, the power pin 204 is used as an example. The second end of the pin may be in a fold line shape partially disposed perpendicular to the first direction, to facilitate surface-mounting onto an external printed circuit board.

FIG. 4 is a diagram of a structure of an intelligent power module according to another embodiment of this application. As shown in FIG. 4, in another possible specific implementation, the power pin 204 is used as an example. The pin may be of a columnar structure as a whole. The second end of the pin may be made into a pad, to facilitate surface-mounting onto an external printed circuit board.

Still refer to FIG. 1. In a possible embodiment, the signal part 200 may further include a second insulation layer 206, and the signal processing chip 201 may be embedded in the second insulation layer 206. Specifically, the signal processing chip 201, the passive component 203, and the like may be embedded in the second insulation layer 206 to form the signal part 200. In other words, the signal processing chip 201, the passive component 203, and the like may be packaged in the second insulation layer 206 through embedding. The pin may extend out of the second insulation layer 206. During specific implementation, the second insulation layer 206 may be formed by using a potting process. The third routing layer 202 may be disposed inside the second insulation layer 206. In other words, the third routing layer 202 may be packaged in the second insulation layer 206 through embedding. Alternatively, the third routing layer 202 may be disposed on a surface of the second insulation layer 206. Relative positions of the signal processing chip 201, the passive component 203, the third routing layer 202, and the pin may be fixed by the second insulation layer 206.

During specific implementation, the second insulation layer 206 may be bonded to the first insulation layer 107. Alternatively, the second insulation layer 206 and the first insulation layer 107 may be made of a same material, so that the second insulation layer 206 and the first insulation layer 107 can be integrally formed.

In a possible embodiment, the intelligent power module may further include a heat dissipation part 300, and the heat dissipation part 300 and the power part 100 may be stacked. Specifically, the power part 100 may be located between the heat dissipation part 300 and the signal part 200. For the whole module, after the module is connected to an external printed circuit board, the heat dissipation part 300 is on a side that is of the module that is away from the printed circuit board. The heat dissipation part 300 may implement heat dissipation of the power part 100 to the outside. This helps quick dissipation of heat of the module. The heat dissipation part 300 may further implement insulation of the power part 100 from the outside.

During specific implementation, the heat dissipation part 300 may include a thermally conductive insulation layer 301 and a heat dissipation member 302. The heat dissipation member 302 may be fastened to the power part 100 through the thermally conductive insulation layer 301. Specifically, the thermally conductive insulation layer 301 may be fastened to the second routing layer 104 of the power part 100, to implement quick heat dissipation of the power part 100. During specific disposition, the thermally conductive insulation layer 301 may be bonded to the power part 100, and the heat dissipation member 302 may be bonded to the thermally conductive insulation layer 301.

During specific implementation, the heat dissipation member 302 may be made of copper or another material with ideal thermal conductivity, and the heat dissipation member 302 may be in a plurality of shapes such as a sheet shape. A material and a shape of the heat dissipation member 302 are not limited in this embodiment of this application. The thermally conductive insulation layer 301 may be formed by using a potting process. The thermally conductive insulation layer 301 and the first insulation layer 107 may be made of a same material, so that the thermally conductive insulation layer 301 and the first insulation layer 107 can be integrally formed. Further, the thermally conductive insulation layer 301, the first insulation layer 107, and the second insulation layer 206 may be made of a same material, and may be integrally formed. In a possible specific implementation, the thermally conductive insulation layer 301 may be a direct bonding copper (DBC) substrate or an active metal brazing (AMB) direct bonding copper substrate, or the like, and may be soldered on the second routing layer 104.

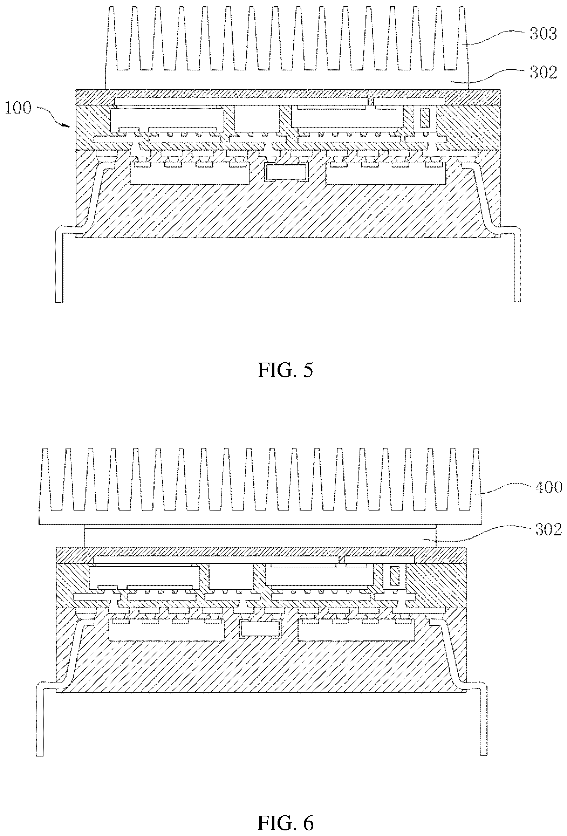

FIG. 5 is a diagram of a structure of an intelligent power module according to another embodiment of this application. As shown in FIG. 5, in a possible embodiment, a heat dissipation fin 303 may be disposed on a side that is of the heat dissipation member 302 and that is away from the power part 100, to improve heat dissipation efficiency. Specifically, the heat dissipation fin 303 and the heat dissipation member 302 may be soldered together or integrally formed. In this specific implementation, the heat dissipation member 302 and the heat dissipation fin 303 as a whole may be considered as a heat sink of the module.

FIG. 6 is a diagram of a structure of an intelligent power module according to another embodiment of this application. As shown in FIG. 6, in another specific implementation, the heat dissipation member 302 may be connected to a heat sink 400 outside the module, to improve a heat dissipation capability. Specifically, the heat sink 400 may be fastened to the heat dissipation member 302 through a thermal interface material (TIM) or solder, so that the heat sink 400 and the module can form a whole through press-fitting or soldering, and a junction surface between the heat sink 400 and the module is tight. This can ensure effectiveness of a heat dissipation capability of the heat sink 400.

In a possible application scenario, in addition to being used as the power transformation functional module of the power supply system, the intelligent power module provided in this embodiment of this application may be further used in another parasitic and heat dissipation sensitive chip packaging field, for example, may be used as a functional module such as a processor or a converter. Specifically, the power chip may alternatively be a chip of a radio frequency, an artificial intelligence (AI), a central processing unit (CPU), a graphic processing unit (GPU), or the like, and the signal processing chip may be a memory or the like. Specific application of the intelligent power module is not limited in this embodiment of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application.

## Claims

1. An intelligent power module, comprising a power part and a signal part, wherein the power part and the signal part are stacked in a first direction;
the power part comprises a power chip and a first insulation layer, and the power chip is embedded in the first insulation layer; and
the signal part comprises a signal processing chip, the signal processing chip and the power chip overlap with each other in the first direction, and the signal processing chip is electrically connected to the power chip.

2. The intelligent power module according to claim 1, wherein the signal processing chip is electrically connected to the power chip through a first via.

3. The intelligent power module according to claim 2, wherein the power part further comprises a first routing layer, the first routing layer is disposed on a side that is of the power chip and that is close to the signal part, and the power chip is electrically connected to the first routing layer.

4. The intelligent power module according to claim 3, wherein the first routing layer is electrically connected to the first via.

5. The intelligent power module according to claim 3, wherein the power part further comprises a second routing layer, the second routing layer is disposed on a side that is of the power chip and that is away from the signal part, and the power chip is electrically connected to the second routing layer.

6. The intelligent power module according to claim 5, wherein the second routing layer is electrically connected to the first routing layer through a second via.

7. The intelligent power module according to any one of claims 3 to 6, wherein the signal part further comprises a third routing layer, the third routing layer is disposed on a side that is of the signal processing chip and that is close to the power part, the signal processing chip is electrically connected to the third routing layer, and the power chip is electrically connected to the third routing layer.

8. The intelligent power module according to claim 7, wherein the third routing layer is electrically connected to the first routing layer through the first via.

9. The intelligent power module according to claim 7 or 8, wherein the third routing layer is electrically connected to a passive component.

10. The intelligent power module according to any one of claims 7 to 9, wherein the third routing layer is electrically connected to a plurality of pins, a first end of the pin is electrically connected to the third routing layer, and a second end of the pin extends out of the signal part.

11. The intelligent power module according to any one of claims 1 to 10, wherein the signal part further comprises a second insulation layer, and the signal processing chip is embedded in the second insulation layer.

12. The intelligent power module according to any one of claims 1 to 11, further comprising a heat dissipation part, wherein the heat dissipation part and the power part are stacked, and the power part is located between the heat dissipation part and the signal part.

13. The intelligent power module according to claim 12, wherein the heat dissipation part comprises a thermally conductive insulation layer and a heat dissipation member, and the heat dissipation member is fastened to the power part through the thermally conductive insulation layer.

14. The intelligent power module according to claim 13, wherein a heat dissipation fin is disposed on a side that is of the heat dissipation member and that is away from the power part.

15. A power conversion device, comprising a circuit board and a power conversion circuit formed by at least one intelligent power module according to any one of claims 1 to 14, wherein the intelligent power module is disposed on the circuit board, the intelligent power module is electrically connected to the circuit board, and the power conversion circuit is configured to perform alternating current-direct current conversion.
